Europäisches Patentamt

European Patent Office

Office européen des brevets

(11) Publication number: **0 025 658**
A2

# (12) EUROPEAN PATENT APPLICATION

(21) Application number: 80302955.2

(22) Date of filing: 27.08.80

(51) Int. Cl.³: **H 01 L 29/80,** G 11 C 19/28,
**H 01 L 21/82,** H 03 H 15/02,
**H 01 L 29/20,** H 03 K 19/08

(30) Priority: 18.09.79 GB 7932313

(43) Date of publication of application: 25.03.81
Bulletin 81/12

(84) Designated Contracting States: DE FR IT NL

(71) Applicant: The Secretary of State for Defence in Her
Britannic Majesty's Government of The United Kingdom
of Great Britain and, Northern Ireland Whitehall, London
SW1A 2HB (GB)

(72) Inventor: Mackintosh, Ian Winstone, 3 Wye Avenue,
Malvern Hereford and Worcestershire (GB)
Inventor: Shrubb, Stephen John Walter, 24 Hampden
Road, Hitchin Hertfordshire (GB)
Inventor: Vokes, John Charles, 11 Grasmere Avenue,
Harpenden Hertfordshire (GB)
Inventor: Wight, David Robert, 54 Whitehall Road, Hitchin
Hertfordshire (GB)

(74) Representative: Robinson, Frederick Robert et al,
Procurement Executive Ministry of Defence Patents 1 A
(4) Room 1932, 19th Floor Empress State Building, Lillie
Road, London SW6 1TR (GB)

(54) Improvements in or relating to charge storage and transfer devices and their fabrication.

(57) A charge transfer device and a method of making the
same, the device including an active layer of semiconductor
material providing charge transfer channel means and supported on a support substrate, a lower array of gate electrodes
for sampling or controlling charge transfer within the transfer
channel means, lower pulse receiver conductors associated
with the lower gate electrodes for reception of phase clocking
pulses, the lower gate electrodes being disposed between the
support substrate and the active layer. The method includes
the steps of forming an active layer of semiconductor material
on the surface of a temporary substrate, forming an array of
lower gate electrodes over the surface of the active layer, applying a support substrate to the surface of the active layer
carrying the lower electrode array, and removing the tempo-
rary substrate. An upper array of gate electrodes may be
formed on the surface of the active layer revealed by removing
the temporary substrate and a double channel structure may
be formed by having an active layer comprising a plurality of
semiconductor layers.

*European Application 0025658*

*UX/5670/04*

1

## IMPROVEMENTS IN OR RELATING TO CHARGE STORAGE AND TRANSFER DEVICES AND THEIR FABRICATION.

This invention relates to charge storage and transfer devices and to methods of fabricating such devices.

Conventional surface channel silicon CCDs are widely used, but their speed, which is an important factor for many applications, is limited by a number of factors. One limiting factor is the speed of the devices used (MOSFETs) in the input and output circuits, which, if they are to be integrated with the CCD on a common substrate, must be made by a compatible technology. Secondly, because such devices are normally designed to operate using substantially square clocking waveforms, their speed of operation is limited by the difficulty of generating such waveforms. In a conventional CCD for example, the device is normally mounted upon a high-capacity substrate. The consequent excess capacity to the clocking electrodes results in problems in producing clean, high-frequency clocking pulses. A further limitation in the speed of such devices is the diffusion limited charge transfer time from one gate to the next, although this difficulty can be reduced to some extent by employing field assisted transfer as for example in buried channel CCDs which are majority carrier devices as described in

1

2

"Peristaltic Charge – Coupled Devices: What is special about the peristaltic mechanism?" LJM Esser, Solid State Imaging, Editor PG Jespers, Noordhoff International Publishing 1976, pages 343 to 425. However, the magnitude of this field is limited because it is essentially a fringing field, the charge packets being sandwiched between the control gates on one side of the channel, and a substrate at a uniform potential on the other.

Some of these limitations associated with silicon CCDs can be overcome by using GaAs instead of silicon, and it has been suggested in I Dehimy et al "GaAs charge coupled Devices" Applied Physics Letters 32(6) 15 March 1978 pages 383 to 385, that multi-gigahertz operation can be achieved in buried channel devices due to the higher charge mobility of GaAs compared with that of silicon. Other GaAs CCDs are described in A J Hughes et al "A CCD on Gallium Arsenide" Proceedings of the International Conference on CCDs, University of Edinburgh, September 1974 page 270, and in W Kellner et al "A Schottky Barrier CCD on GaAs", Digest of the IEEE Electron Devices meeting, Washington DC, December 1977 page 599.

A common feature of all known CCDs, whether Si or GaAs, is that they comprise an array of charge transfer electrodes overlying the free surface of the active channel region which is usually supported on a substrate of the same semiconductor material. This arrangement has a number of major limitations. Firstly, the potential wells within the channel region can only be induced from one side of the channel region, effectively limiting the charge

3

transfer field strengths which can be applied;
secondly for imaging applications, the presence of
the charge transfer electrodes impedes the transmission
of incident radiation into the channel region. Also,
logic gates fabricated using this basic design use
a relatively large area of substrate and are concomitantly relatively slow in operation.

It is an object of the present invention to
provide an improved charge transfer device, some of
the improvements in which include means for overcoming or at least substantially reducing the effect
of the above disadvantages.

According to the present invention a charge
transfer device includes an active layer of semiconductor material providing charge transfer channel
means, and supported on a support substrate, a lower
array of gate electrodes for sampling or controlling
charge transfer within the transfer channel means,
lower pulse receiver conductors associated with the
lower gate electrodes for reception of phase clocking
pulses,  the lower gate electrodes being disposed
between the support substrate and the active layer.

4

Preferably the channel is formed of GaAs semiconductor material, although any other suitable material may be used, for example, silicon, indium phosphide (InP) or gallium aluminium arsenide (Ga Al As).

Preferably the charge transfer device is a buried channel CCD and each of the gate electrodes forms a rectifying junction, eg in the case of GaAs devices, a Schottky-barrier junction with the semiconductor material of the channel.

The configuration of a charge transfer device in accordance with the invention may be substantially the same as conventional charge transfer devices with the exception that at least the gate electrodes are disposed beneath the active layer of the device rather than on the free upper surface thereof. Thus conventional design techniques may be used in determining the parameters of the device, which may be typically a two, three or four phase device. Further the device may readily be adapted to operate as a transversal filter in known manner, by splitting appropriate gate electrodes at a point along their length to introduce a characteristic weighting function. In imaging applications, the unsupported surface of the channel can remain free to receive incident radiation, as the charge transfer electrodes are provided only on the mechanically supported side of the channel.

4

5

Alternatively, the device may include a second array of gate electrodes overlying the unsupported side of the active layer.

The provision of an electrode array on both sides of the active layer enables a number of novel device configurations to be achieved. For example, the two electrode arrays may be arranged to control the transfer of charge along a common channel in the active layer sandwiched between them. Because controlling electric potentials can be applied to the channel from both sides, greater electric fields along the channel can be obtained, enabling faster charge transfer times to be achieved. The two electrode arrays are preferably substantially identical, and may be symmetrically aligned with one another on opposite sides of the active layer, so that in operation the charge is constrained to move in the central plane of symmetry between them.

Alternatively, the two electrode arrays may be staggered with respect to one another in the direction of charge transfer, preferably by half a gate pitch, so that in operation the charge packets describe a zig-zag path through the channel region, enabling even faster transfer times to be achieved.

Again such devices may be adapted to operate as transversal filters. Where the two electrode arrays are symmetrically aligned with respect to one another, corresponding electrodes on opposite sides of the active layer may both be weighted equally, or each pair of corresponding electrodes may be differently weighted, to achieve a desired filter characteristic.

The corresponding electrodes of both arrays may be interconnected with one another so that both arrays can be driven by common clocking potentials. Alternatively the two electrode arrays may be isolated from one another, enabling each array to be independently controlled. In such an arrange-

5

6

ment, the two electrode arrays may be adapted to perform different functions. For example, the electrodes of one array may be adapted to control the transfer of charge along the array, while the electrodes of the other array may be adapted to operate solely as charge sampling electrodes. The sampling electrodes of this array may then be differently weighted, and selected ones interconnected in any suitable manner to provide a number of different transversal filtering characteristics. Advantageously, the device may include an array of logic gates integrated on the same substrate and adapted to variably control the interconnection of the sampling electrodes to vary the filtering characteristics of the device.

The dopant concentration of the active layer need not be uniform throughout its thickness, and variations of the dopant concentration may be introduced in known manner either to improve the charge handling capacity, to optimise the position of the potential well in the depth of the channel region, or to improve the quality of any ohmic or low resistance contacts made to the active layer, eg at the input and output circuits.

For some applications, in devices having gate electrode arrays on both sides of the active layer, the electrodes of the two arrays need not be parallel. For example, independently controllable electrode arrays on opposite sides of the active layer may be disposed at $90^\circ$ with respect to one another, effectively defining a two-dimensional matrix array of charge storage locations at the cross-over points of the two electrode arrays. Such an arrangement has applications in signal processing, memory and logic applications, and for such applications, the active layer may advantageously comprise GaAlAs, enabling very long storage times to be achieved. Furthermore, in such two-dimensional devices, the individual regions of

6

7

the active layer defined at the cross-over points
of the two electrode arrays may be isolated from
one another, either by removing portions of the
active layer surrounding each of these regions to define
active mesas at the cross-over points, or by
isolation of such portions of the active layer using
proton or ion beam bombardment techniques in known
manner.

According to further embodiments of the present
invention, the active layer may comprise a plurality
of layers of semiconductor material sandwiched
between two electrode arrays, the semiconductor
properties of the layers being such that, in
operation, a barrier junction can be produced at or
near the interface between adjacent layers of the
structure. These barrier junctions may either
comprise homo-junctions, the structure comprising
layers of the same material; or they may comprise
hetero-junctions, the structure comprising layers
of different materials. A first example of this is
a two-layer structure having an upper and lower
layer. The upper layer could then for instance be
used for imaging purposes, charge packets then being
moved to the lower layer for transfer.

A second example of a multi-layer structure is
a three-layered active layer. Homo-junction forms may
then comprise n-p-n layers or p-n-p layers. Heterojunction forms may comprise layers of either the same
or different conductivity type (p or n type) and
preferably comprise an intermediate layer of a first
material sandwiched between two outer layers of a
different material. For example, the two materials

8

may be GaAs and GaAlAs providing either a
GaAs/GaAlAs/GaAs structure or  a GaAlAs/GaAs/GaAlAs
structure.  Again, the dopant concentrations of each
layer of semiconductor material may vary through its
thickness  for the reasons outlined above.

In devices having an active layer with a three-
layer structure, the two outer    regions of the
active layer provide seperate charge transfer channels
isolated from one another by the intermediate region,
the two electrode arrays being adapted to sample
and/or control the transfer of charge in a respective
one of the two channel regions.  The three regions of
the active layer structure may be fully depleted in
the absence of injected charge, so that in operation
charge is constrained to move within the channel
regions upon application of  suitably small clocking
potentials to the associated electrode array.
Charge may then be transferred from one channel to the
other across the intermediate region by local
application of a suitably large bias between opposing
electrodes of the two arrays.  Alternatively the
intermediate region may not be fully depleted in
the absence of injected charge, the two outer channel
regions of the active layer being fully depleted, the
device including means for applying potential bias
to this intermediate layer.  Charge may then be transferred from one of the channels to the other
by applying a suitable bias between opposing elect-
rodes of the two arrays and applying a suitable
voltage pulse to the intermediate layer.

9

Such a device may be regarded as two separate charge transfer devices, each capable of performing a different function, eg transversal filtering, with the capability of rapidly switchingcharge between them. Further, the two charge transfer devices may be operated at different clocking speeds with the same or opposite directions of charge transfer. Again, for some applications, the electrodes of the two arrays need not be parallel, for example they may be disposed at 90$^{\circ}$ with respect to one another, defining a two dimensional matrix array of storage locations suitable for memory and logic applications. For such applications, the channel regions may advantageouslycomprise GaAlAs, enabling very long storage times to be achieved. Again, the individual regions of the active layer defined at the cross-over points of the two electrode arrays may be isolated from one another, as aforesaid.

A multiple layer structure also affords the ability to move charge packets in loops within the active layer. This has application to, for example, CCD memories. Additionally, the consequent ability of electrodes to sample the same charge packet more than once results in the possibility of complex signal processing applications.

Another application of multi-layer devices is to logic function devices. In, for example, a device having an active layer comprising two charge transfer channels with symmetrical independent electrodes, corresponding upper and lower potential wells may be used to represent two inputs to a logic gate, an output being taken from either of the wells after application of voltage pulses to effect logic operations.

According to a second aspect of the present invention, a method of fabricating a charge transfer device comprises the steps of forming an active layer of semiconductor material on the surface of a temporary substrate, forming an array of gate electrodes over the surface of the active layer, applying a support substrate to the surface of the active layer carrying the electrode array, and removing the original substrate.

Preferably a second array of gate electrodes is formed over the unsupported side of the active layer following removal of the temporary substrate.

The temporary substrate may be removed by any suitable technique, advantageously by selective etching using an etching process which does not affect the active layer or which removes the temporary substrate material immediately adjacent to the active layer at a faster rate than it removes the active layer.

Preferably the temporary substrate comprises a first relatively thick layer of semiconductor material formed with a relatively thin buffer layer of semiconductor material of a different type, the active layer then being grown on the surface at the buffer layer. Removal of the substrate may then comprise removal of the first layer against the buffer layer using a selective etching technique, followed by removal of the buffer layer against the active layer by a second selective etching technique. The selective etching techniques may be electo-chemical, chemical or a combination of both.

Alternatively, a temporary substrate comprising more than two layers may be used to obtain an active layer of particularly even thickness. This approach is especially useful when the materials used are
such that the difference in etch rates between the
substrate layers and between the substrate and active
layer is not very large as is found, for instance, in
silicon technology.

In a preferred method, the active layer comprises
GaAs epitaxially grown on the surface of a temporary
substrate comprising a relatively thick first layer
of GaAs formed with a relatively thin epitaxial buffer
layer of GaAlAs, the temporary substrate being
removed by a combination of two selective etching
techniques. Preferably the buffer layer is between
$\frac{1}{2}$ to 2 microns thick, and the active layer is between
2 to 3 microns thick.

Conveniently the supporting substrate may be
applied by first forming on the surface of the
structure supported by the temporary substrate, a
thin coating of insulating material, and then bonding
the supporting substrate to the coating, for example
using an adhesive. The coating may conveniently
comprise a polyimide. Because the support substrate
is isolated from the device structure by an insulating
coating, the supporting substrate may be of conducting
or non-conducting material and may be chosen to give
a small capacity to the electrodes in order to permit
the use of high clocking frequencies.

Further, in devices fabricated by a method in
accordance with the present invention, because the
temporary substrate is removed during the fabrication
process, its properties are irrelevant to the
subsequent operation of the device, and a wider range
of starting substrate materials than have hitherto
been conventionally employed, may be used.

12

In a further preferred form of method in accordance with the invention, the active layer is formed as a structure having a plurality of layers as aforesaid and having barrier junctions at the interfaces between the layers, the device being formed with respective arrays of gate electrodes at both sides of the active layer, and the two layers adjacent to the electrodes providing charge transfer channels, one for each array of electrodes. In the case of a three layer structure these are seperated from one another by an intermediate layer.

In both the single and multi-layer active layer devices, the dopant concentration of the or each layer may be non-uniform through its thickness for the reasons outlined above.

The invention will now be described in greater detail by way of example only with reference to the accompanying drawings, of which:-

Figure 1(a) to (c) represents schematically, in sectional elevation various stages in a method of fabrications a charge transfer device in accordance with the present invention;

Figure 2 represents schematically a plan view of a charge transfer device fabricated by the method illustrated in Figure 1;

Figure 3 is a schematic longitudinal sectional elevation of a further form of charge transfer device in accordance with the invention;

Figure 4 is a schematic transverse sectional elevation of the device shown in Figure 3 along the line IV - IV;

Figure 5 is a schematic plan view of part of a further form of charge transfer device in accordance with the present invention;

Figure 6 is a schematic longitudinal sectional elevation of part of a further form of device in accordance with the present invention;

Figure 7 is a schematic longitudinal sectional elevation through part of a modified form of the device shown in Figure 6;

Figure 8 is a schematic longitudinal sectional through part of a further form of charge transfer device in accordance with the present invention;

Figure 9 is a schematic longitudinal sectional elevation through a further form of charge transfer device;

Figures 10(a) to 10(c) schematically illustrate in traverse cross-section various stages in a modified fabrication procedure for the device shown in Figure 9;

Figures 11 and 12 are schematic longitudinal sectional elevations through two further forms of charge transfer device in accordance with the invention;

Figure 13 is a graphical plot illustrating an operation of the device shown in Figure 12;

14

Figure 14 shows schematically a modified form of the device shown in Figure 12; and

Figure 15 is a schematic sectional view of a further modified form of the device shown in Figure 12.

Figure 16 is a schematic representation of a portion of the device in Figure 12.

Figure 17 is a graphical plot illustrating an operation of the device in Figure 16.

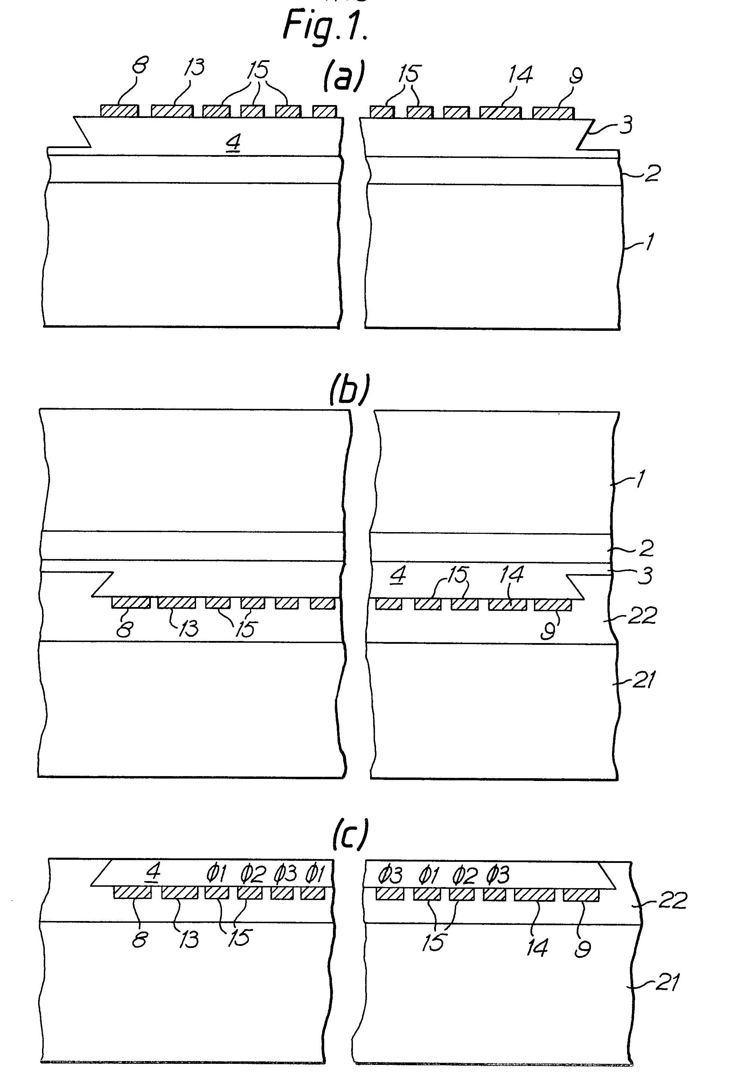

Referring to the drawings, the fabrication procedure illustrated in Figs 1(a) to 1(c) initially comprises forming a GaAlAs buffer layer 2 of the order of $\frac{1}{2}$ to 2 micron thick on the surface of a semi-insulating (SI) GaAs substrate 1, typically several hundred microns thick, and forming on the GaAlAs buffer layer 2, an active layer 3 of n-type GaAs having a dopant concentration, suitable for supporting CCD charge transfer, between about $1 \times 10^{15}$ to $5 \times 10^{16}$ carriers/cm$^3$. The thickness of the active layer 3 is typically of the order of 2 to 3 microns, both the buffer layer 2 and the active layer 3 being formed by liquid or vapour phase, or molecular beam epitaxy using known techniques.

0025658

15

Following formation of the epitaxial semiconductor layers 2,3, a mesa 4 is formed in the
active layer 3 using an orientation selective etchant,
such as a 95:5 mixture of 100V $H_2O_2$ and 35% $NH_4OH$,
to define the active channel region of the device.
By appropriate selection of the orientation, a mesa
4 having an undercut profile at each end (see Fig 1(a))
and having an outwardly sloping profile along its longitudinal
edges, may be formed. The mesa etch may extend
right through the thickness of the active layer 3
down to the buffer layer 2, although preferably, as
shown, it extends only partially through the active
layer to leave a thin layer of active material
surrounding the mesa 4. Typically, starting with
a 3µm thick active layer 3, a 1 micron thick layer
may be left around the mesa after etching.

Input and output electrodes 8,9 are then formed
as ohmic contacts on the surface of the active
layer 3 at opposite ends of the channel mesa 4
using known techniques.                    Each of

15

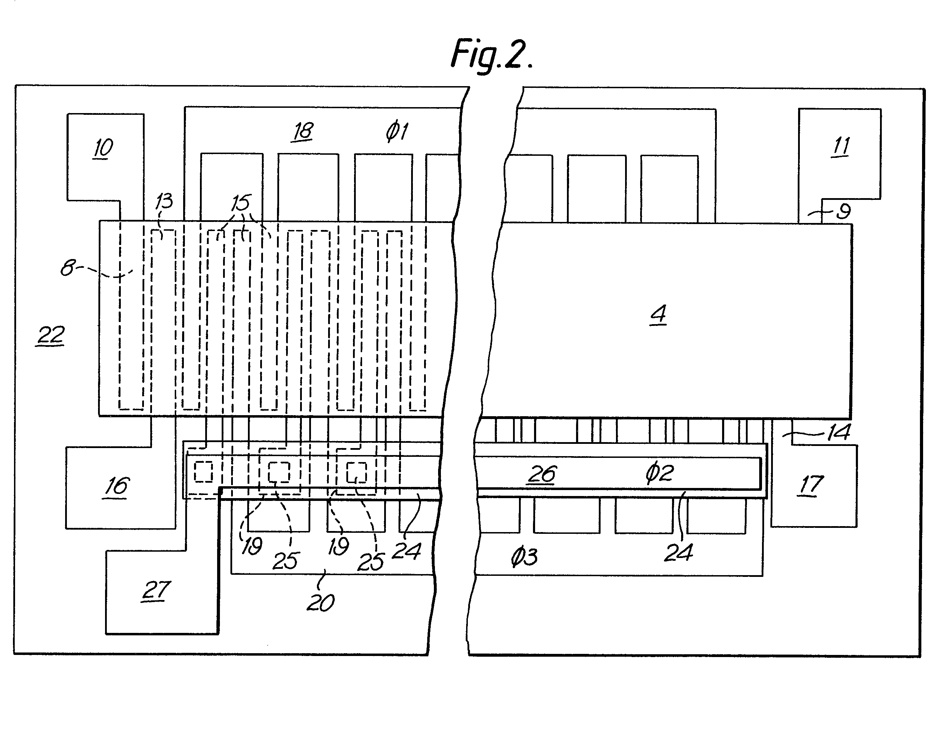

these electrodes is in the form of an elongated finger extending
transversely across the mesa (see Fig 2) and terminating at
one end off the mesa, in a respective contact pad 10, 11.
Continuity of the electrodes as they pass over the edge of the
mesa is ensured by the outwardly sloping profile of the mesa
edge.

A CCD array of Schottky barrier electrodes is then formed
on the surface of the structure by a standard lift-off or
float-off technique. The array comprises input and output transfer gates 13, 14 adjacent the associated
input and output electrodes 8, 9, and a three-phase array
of charge transfer electrodes 15. As seen in Figure 2, each
of these transfer electrodes 13, 14, 15 is in the form of an
elongated finger, extending transversely across the channel
region parallel to the input and output electrodes 8, 9 and
equally spaced apart (by approximately 1μm) along the channel
region. Typically, the input and output transfer gates are
approximately 5μm wide, and each of the charge transfer gates
15 is 3μm wide.

The input and output transfer gates 13, 14 each terminate
at one end off the mesa 4, in a respective contact pad 16, 17.

The charge transfer gates 15 are divided into three sets
of electrodes, one set for each clocking phase$\phi_1$, $\phi_2$, $\phi_3$ of
the three phase CCD. Commencing at the input end of the
device, the 1st, 4th, 7th etc gate electrodes 15 provide the
$\phi_1$, electrodes and each extend across one edge of the channel
mesa 4 and terminate in a common bus line 18; the 2nd, 5th
8th etc electrodes 15 provide the $\phi_2$ electrodes and each
extend across the opposite edge of the channel mesa 4 and
terminate in respective contact pads 19; and the 3rd, 6th,
9th etc electrodes 15 provide the $\phi_3$ electrodes of the device
and extend over the same edge of the channel mesa as the $\phi_2$
electrodes, into a common $\phi_3$ bus line 20 as shown in Fig 2.

Following the formation of the Schottky barrier electrode configuration on the surface of the active layer, an insulating support substrate 21 Fig 1(b) is bonded to the surface of the structure carrying the electrodes using any suitable low temperature technique which does not adverseley affect the existing structure. A suitable technique comprises the formation of an initial coating 22 of insulating material, compatible with the GaAs active layer and the electrode structure, to which the second substrate is bonded using a suitable adhesive. One suitable insulating material for the coating 22 , is polyimide, such as that  sold under the name of KERIMID (Registered Trade Mark) 601 by Rhone Poulenc, an addition-type polymer. The material, which is sold in powdered form, is dissolved in a solvent and applied to the surface of the existing structure which is then spun at high speed to achieve a uniform coating of desired thickness. The coating is then dried at a temperature of about $120^{\circ}$C before curing at a temperature of about $220^{\circ}$C to give a hardened coating. To provide a coating 22 of improved quality, it may be built up from a number of successively applied thinner layers (typically of submicron thickness), successive layers being cured before application of the next.

Any suitable adhesive may then be used to affix the insulating support substrate 21 to the coating 22. For example an epoxy resin may be used or, as in the present embodiment, a similar polyimide material as the coating 22 which may be applied either as a solution and then cured to form the bond, or in powder form, sandwiched under pressure between the insulating substrate 21 and the coating 22, and then heated to curing temperature. The insulating
substrate may comprise for example alumina, glass or
a plastics material. Alternatively, the substrate 21
may be of conducting of semiconducting material,
its conductivity having no effect on the active layer
as it from it by the bonding medium.
    is isolated

The purpose of the insulating support substrate
21 is to provide a mechanical support for the active
layer 3 and the electrode structure associated with
it, so that the original semiconductor substrate 1
can be removed with the buffer layer 2 exposing the
opposite surface of the active layer to that on which
the electrode structure is formed. Removal of the
original GaAs substrate 1 is effected by using a
selective etching proceedure in which the GaAlAs
buffer layer 2 provides a chemical stop for the
etchant used in removing the GaAs substrate 1,
following which the buffer is removed using an
etchant to which the active layer 3 is resistant.
In this way, a very thin, highly uniform epitaxial
layer of high quality GaAs material supported on an
insulating substrate can be achieved.

The original semi-insulating GaAs substrate 1 is
removed using a 95:5 $100VH_2O_2$, $35\%NH_4OH$ mixture which
attacks GaAs at a much faster rate (about 2 orders
of Magnitude) than it attacks GaAlAs, causing the
etch to stop abruptly at the GaAs/GaAlAs interface.
The GaAlAs buffer layer 2 is then removed using a
different etchant, a 50% solution of HF, which attacks
the GaAlAs at a faster rate than it attacks GaAs,
the rate being dependent upon the proportion of Al in the GaAlAs layer, (in the present example, $Ga_{0.4}$ $Al_{0.6}$ As is used). Because the buffer layer 2 is relatively thin, $\frac{1}{2}$ to 2 mictons, its removal can be effected without affecting the uniformity of the active layer 3.

Following removal of the GaAlAs buffer layer 2, the approximately 1 micron-thick surface thickness of GaAs in the active layer 3, left by the earlier partial removal of active GaAs to form the mesa 4, is now removed by free etching to expose those parts of the input and output electrodes 8, 9 and the Schottky barrier electrode array 13, 14, 15 together with their respective contact pads and bus lines 10, 11, 16, 17, 18, 19, 20 which do not underlie the mesa 4. In this process, the channel mesa 4 becomes completely isolated and its depth is reduced to the required depth of about 2 microns.

To provide a common interconnection between the contact pads 19 of the $\phi_2$ gate electrodes 15, an insulating overlay 24 is formed between one edge of the mese 4 and the $\phi_3$ bus line 20 as shown in Fig 2. In this example, the overlay 24 comprises a layer of polyimide material, applied in solution over the entire surface of the device and reduced to an appropriate thickness by spinning. After drying and before full curing, parts of the overlay are etched through a photolithographic mask using the resist developer as the etchant, to leave the
configuration shown having windows 25 through to
the contact pads 19, and the overlay 24 is then
fully cured. A $\phi_2$ metallic bus line 26, interconnecting these contact pads through the windows 25, and
terminating in an enlarged contact pad 27 is then
formed on the overlay 24. Alternatively, the
geometry of overlayer 24 may be defined by ion
milling or plasma ashing after spinning  on the
polyimide material. Also, the overlay may alternatively be provided by a layer of sputtered $SiO_2$,
etched using HF.

The resulting device is shown in section in
Fig 1(c) and in plan in Fig 2, comprising a planar
CCD having a conventional configuration, but in
which the input, output and charge transfer gate
electrodes are buried beneath the channel region 4
leaving the opposite surface of the active layer 3
interfaced to air. Apart from the advantages of
interfacing the active channel on one side to a
good insulator, and on the other side to air (as
opposed to a semi-insulating  GaAs in conventional
GaAs CCD devices), this novel configuration has
particular advantages in its applications as an
imaging device, because the free surface of the
channel region opposite the charge transfer electrodes
provides an unimpeded surface for receiving incident
radiation.

In such imaging applications, the ohmic input contact 8
and its associated input transfer gate 13 would not be required
as the charge is injected directly into the CCD storage sites
by the diffusion of charge created by the absorption of photons
incident on the free surface of the channel region.

Alternative fabrication procedures may readily be used.
For example, the channel-defining mesa 4 may equally be formed
after the removal of the temporary substrate and buffer layer 2,
instead of before formation of the electrode structure. In
this case it would be preferable to adopt the alternative etch
orientation to that described, so that in the completed device
the longitudinal edges of the mesa 4 slope outwardly.
Alternatively, the mesa may be formed by an orientation-
independent material removal process, such as by ion beam
milling.

Furthermore, whichever mesa formation process is used, the
overlay 24 for the $\emptyset$ 2 electrodes may be formed before the
formation of the gate electrode array 13, 14, 15, so that
following removal of the substrate 1 and buffer layer 2, and
isolation of the mesa 4 (whenever this is done), the overlay
is exposed to permit the interconnecting bus line 26 to be
formed. As an alternative to this procedure, the interconnecting bus line 26 may be formed before the formation
of the overlay 24, so that the contact pads 19 of the
subsequently formed $\emptyset$2 gate electrodes 15 make contact with the
bus line 26 through the windows 25.

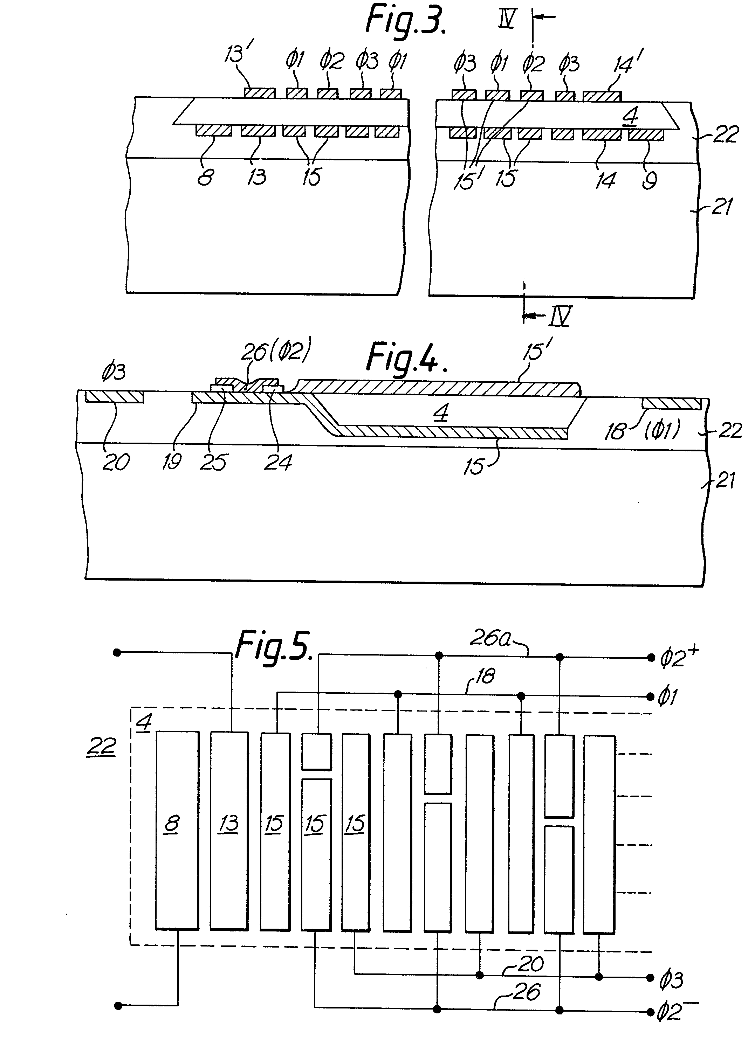

A further advantage of the fabrication process in
accordance with the present invention, is that electrodes may
be provided on both sides of the active layer 3 as illustrated
in Figure 3. Here the device is essentially the same as that
described with reference to Figures 1 and 2 except that
a second array of Schottky gate electrodes 13',14',15', substantially identical to and aligned with the first array 13, 14, 15, is also formed on top of the device using known techniques. The corresponding transfer electrodes 13, 14, 15, 13', 14', 15' of each array make contact with one another off the mesa 4 so that both arrays are driven by the same driving potentials.

In some applications, it may be desirable to provide ohmic input and output contacts as part of the overlying electrode structure instead of, or in addition to, those of the underlying electrode structure.

A cross section through the Figure 3 device is shown in Figure 4 in which elements of the upper electrode structure corresponding to those of the lower electrode structure are denoted by a prime.

On application of three-phase clocking potentials to the transfer electrodes 15, 15', charge packets injected into the device via the ohmic input electrode(s) 8 (8) and Schottky barrier input gates 13 , 13' will propagate within the channel region along the central symmetry plane between the two sets of transfer electrodes 15, 15', compared to conventional CCDs having charge transfer electrodes on only the top surface of the channel region, the Figure 3 device enables a faster charge transfer time and a higher transfer efficiency due to the stronger electric fields made possible by the symmetrical structure.

Again, for imaging applications, the ohmic input contact 8 and transfer gates 13, 13' may be omitted. Furthermore, the upper array of transfer electrodes 13' 14' 15' may be formed of a transparent conducting material, such as highly doped GaAlAs at least in the region overlying the channel mesa, to allow the transmission of incident light. However, for most applications this is not necessary, and adequate if not better resolution can normally be achieved using non-transparent metal electrodes, incident light entering the device through the spaces between the electrodes 15'.

23

The single-sided CCD shown in Figures 1 and 2, may be adapted to operate as a transveral filter by weighting the transfer electrodes of one of the phases, eg $\emptyset 2$. This may be achieved in known manner by splitting each of the weighted ($\emptyset 2$) electrodes into two sections ($\emptyset 2^+$ and $\emptyset 2^-$) at a point along its length, so that the difference in the operative areas of the two sections is proportional to the desired weighting coefficient. In a typical implementation all the $\emptyset 2^+$ and all the $\emptyset 2^-$ electrode sections are connected to respective $\emptyset 2^+$ and $\emptyset 2^-$ clocking bus lines 26a, 26 as shown in Figure 5. The difference between the integrals of the drive currents detected on these two bus lines gives an output proportional to the convolution of the CCD input signal with the impulse response determined by the weighting coefficients, as is well known in the art.

In fabricating such a transversal filter, isolation of the required additional bus line 26a from the $\emptyset 1$ electrodes, which bus line will be located on the opposite side of the channel mesa 4 to that on which the existing $\emptyset 2$ bus line 26 is located, is achieved using a similar overlay technique to that used for the existing bus line 26.

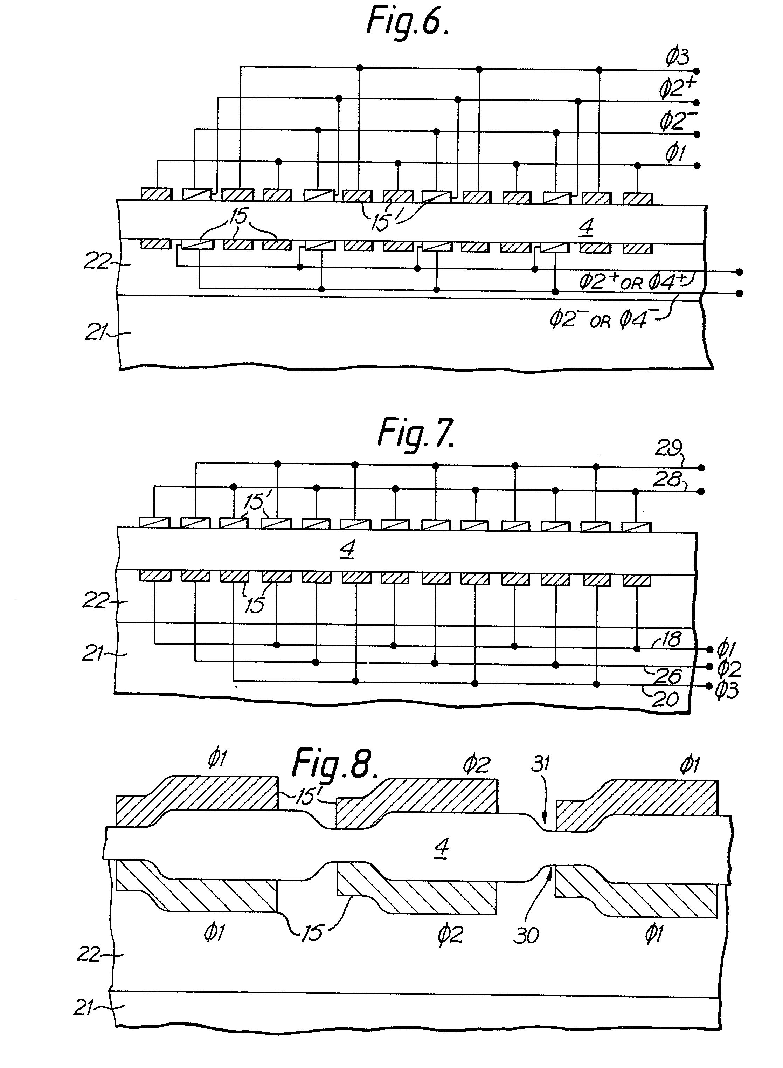

Similarly, the double sided CCD shown in Figure 3 may also be adapted to operate as a transversal filter, as illustrated in Figure 6 by splitting the electrodes of one clocking phase. In the device shown in Figure 6, each opposing pair of $\emptyset 2$ electrodes have the same tap weight (ie they are split at the same point along their length), although the tap weight will vary from pair to pair along the device in accordance with the desired frequency characteristics. Thus, as in the Figure 3

23

24

embodiment, the corresponding transfer electrodes 13, 14, 15; 13', 14', 15' of each array may conveniently make contact with one another off the mesa 4, so that the electrodes of both arrays can be driven by the same driving potentials. However, as discussed in connection with the transversal filter implementation shown in Figure 5, separate clocking bus lines $26a, 26$ are required for the $\emptyset2^+$ and $\emptyset2^-$ electrodes, and again the $\emptyset2^+$ bus line 26a may conveniently be provided on the opposite side of the mesa to the $\emptyset2^-$ bus line 26, both being isolated by the overlay technique used for the bus lines 26, 26a in Figure 5.

Alternatively, the weighted electrodes of the electrode array on one side of the mesa, 4, may be associated with a fourth phase, $\emptyset4$ in Figure 6, in which case they will be isolated from the corresponding weighted electrodes $\emptyset2$ of the array on the opposite side of the channel layer, although the $\emptyset2$ and $\emptyset4$ checking waveforms in such an arrangement will be in phase with one another. Isolation of the weighted $\emptyset2^+$, $\emptyset2^-$ from the $\emptyset4^+$ and $\emptyset4^-$ electrodes may be effected using similar overlay techniques to those previously described, although it will be seen that an additional layer of overlay material is required between the $\emptyset2$ and $\emptyset4$ electrodes and their associated bus lines, to isolate them from one another.

A further advantage of being able to fabricate CCD electrodes on both sides of a thin semiconductor layer is that, although electrodes on both sides of the channel can be coupled to the same charge packets, the electrodes on one side can be used to perform a different function to those on the other side.

24

25

For example, the gates on one side of the channel region can be used for charge transfer by applying clocking waveforms to them in a conventional manner, while those on the other side can be used for non-destructive charge sampling. A particular variant of this is to use the electrodes on one side to implement a transversal filter. These sampling or tapping electrodes may then be interconnected in sets of every $n^{th}$ electrode, the electrodes of each set being split to provide the appropriate weighting coefficient, enabling n different filtering functions to be performed simultaneously. A device of this type is illustrated in Figure 7, in which the underlying charge transfer electrodes 15 are suitably interconnected to provide 3-phase clocking, while those 15' on the top surface are interconnected in two sets ($\underline{n}$ = 2), by summation lines 28, 29 to provide two separate transversal filters, with the electrodes of each set split to provide the required filtering functions.

Because the sampling electrodes of this type of CCD configuration are not used for clocking purposes, and hence do not need to be associated with a particular clocking phase as was the case in the Figure 6 device, the electrodes of each set selected for a particular filtering function need not be regularly spaced along the CCD array - any desired combination may be chosen. Further novel signal processing applications can be achieved by connecting individual ones, or sets of non-clocking electrodes, either continuous or split, direct to logic gates which may be monolithically integrated with the CCD. In this connection, it should be noted that each split electrode need be tapped from only one end to derive the necessary signal

26

information.

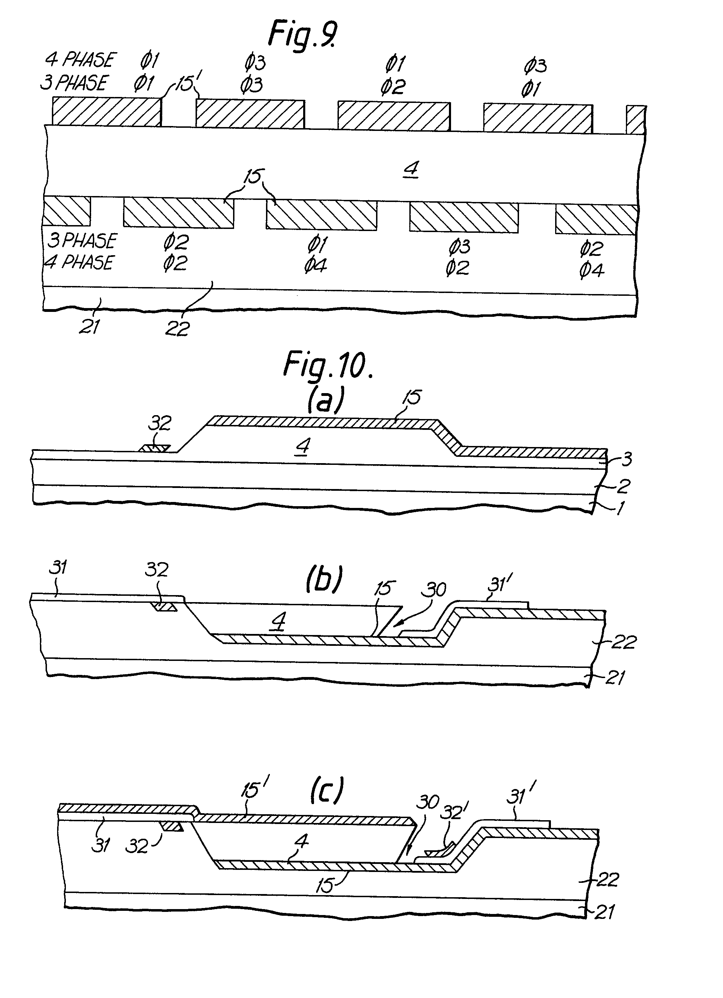

Each of the devices so far described may be adapted for 2 phase CCD operation by providing a progressive or stepped increase (in the direction of charge transfer) in the thickness of the active layer, beneath each clocking electrode in the case of the devices having clocking electrodes on one side only, and between each pair of opposed clocking electrodes in the case of devices having clocking electrodes on both sides of the active channel region. Figure 8 shows a modification of the Figure 3 double-sided clocked device, adapted for 2 phase operation.

The fabrication procedure is substantially the same as that for the Figure 3 device with the following major differences. Prior to formation of what will eventually be the underlying electrode structure comprising gate electrodes 15, recesses 30 are formed in the active layer 3 extending transversely across the active channel region at spaced intervals, using ion milling or plasma ashing. A 2 phase array of Schottky barrier transfer gates 15 is then formed in the same manner as before, each gate being of increased width (approximately 4 microns) with approximately 1 micron separation. Each electrode 15 overlies that edge of a respective one of the recesses which is stepped outwardly in the direction of charge transfer.

Following application of the insulating support substrate 21, removal of the Ga As substrate 1 and Ga AlAs buffer layer 2, and any other fabrication steps required for ohmic contact

26

and mesa formation in devices in which these are formed after removal of the first substrate, corresponding recesses 31 are formed in the top surface of the active layer, opposite to and aligned with those previously formed in the now underlying surface of the active layer. The top surface Schottky barrier electrode array is then formed in the usual manner, and the transfer gates 15', again being of increased width, are aligned with the underlying electrodes 15' lying on opposite sides of an edge of a respective one of the recesses 31 as shown.

As before, in forming the top and bottom electrode structures, each electrode is formed with a portion extending across the edge of the channel region 4 and terminating either in a contact pad portion in the case of the ohmic input and output contacts and the input and output transfer gates, or in a clocking bus in the case of charge transfer electrodes 15, 15'. The two phase operation of such devices simplifies the electrode configuration in that the clocking buses of the respective phases may be located on opposite sides of the channel region without overlay complications associated with 3 phase devices. The contact pads and clocking buses (not shown) associated with the underlying electrode structure are exposed upon formation of the channel mesa 4. The electrodes of the subsequently formed top electrode structure 15' are then formed with portions which extend over the downwardly sloping lateral edges of the mesa 4 (due to the selected orientation of the mesa etch) into contact where appropriate with the corresponding portions of the lower electrode structure. Typically the depth of the active layer in the recessed regions is about 0.8 $\mu$m, and about 1.6 $\mu$m elsewhere.

28

The operation of the device is similar to that of conventional single sided 2-phase CCDs, with the advantage that increased electric fields, and hence faster clocking times, are possible, due to the symmetric geometry of the device.

A further modification of the device shown in Figure 3, is illustrated in Figure 9, in which the charge transfer electrodes 15, 15' of the lower and upper electrode structures are displaced by half a gate period with respect to one another, with the result that in operation the charge packets describe a zig-zag path along the channel region 4. Typically, the width of each electrode 15, 15' is approximately 3 microns, with a gate separation as before of about 1 micron, and a channel depth of the order of 2 microns. Faster charge transfer times and higher charge transfer efficiency than are possible with the Figure 3 device can be obtained due to the possibility of achieving larger fields with this geometry. Both three and four phase clocking may be employed as illustrated, four phase clocking having the advantage of simplified gate interconnections as it requires only two phases on each side of the active channel region 4.

It will be seen that in fabricating devices of this kind, it is necessary to ensure that the electrodes on opposite sides of the channel layer do not contact one another, and it is also desirable to ensure that each transfer electrode extends across the whole width of the channel. This may conveniently be achieved using an angled evaporation technique to form at least one of the electrode arrays 15, 15'.

The fabrication procedure is generally similar to that described with reference to the Figure 3 device, except that, for a four phase device, gate electrodes for only two phases, either $\emptyset 1$ and $\emptyset 3$, or $\emptyset 2$ and $\emptyset 4$, need be formed on any one side of the active channel layer 4. Referring now to Figure 10,
following formation of the active mesa 4 as before, the $\emptyset 2$
and $\emptyset 4$ gate electrodes 15 are formed on the surface of the
mesa 4, with portions thereof extending over the same lateral
edge of the mesa (as shown in Fig 10(a) the right hand edge)
to provide means for external connection to respective sources
of clocking potential. The electrode configuration may be
similar to that shown for the underlying $\emptyset 2$ and $\emptyset 3$ clocking
electrodes of the Figure 2 device, in which one set of
electrodes, say the $\emptyset 2$ electrodes, terminate in a common
clocking bus(not shown) and the other set, the $\emptyset 4$ electrodes
15 , each terminate in a separate contact pad (not shown)
which are later interconnected by means of a subsequently
formed $\emptyset 4$ bus line in the manner described for the $\emptyset 2$
electrodes of the Figure 2 device.

The $\emptyset 2$ and $\emptyset 4$ electrodes are formed by an angled evaporation technique (see Fig 10(a), which is a transverse cross-
section through the structure) which ensures that the
electrodes extend fully across the width of the mesa. Any
superfluous metallization 32 deposited deposited on the
surface of the structure along the left hand edge of the mesa,
as shown, is isolated from that on the top surface of the mesa,
due to shadowing of the angled evaporation by the mesa. This
superfluous metallisation 32 is required for no other purpose
than to allow a margin of error in the alignment of the
metallisation pattern, and ensure that the metallisation
pattern formed on the top surface of the mesa extends fully
across the width of the mesa.

The structure is then bonded face down onto a support
substrate 21 using the same techniques as before, and the

30

temporary substrate 1, the GaAlAs buffer layer and the
remaining partial thickness of the active layer are then
removed to finally isolate the mesa 4 and expose the portions
of the $\phi$2 and $\phi$4 metallisation not covered by the mesa

A thin strip of the mesa 4 is then removed
(see Figure 10(b))
to leave a recess 30 at the edge of the mesa across which
the $\phi$2 and $\phi$4 electrodes extend to their respective contact
pads or bus lines. Areas 31,31' of insulator, eg $SiO_2$, are
then formed along the edges of the mesa 4, the area 31
covering the superfluous metallisation 32, and the area 31'
covering parts of the electrode array 15 as it extends
across the floor of the recess 30. The metallisation for
the $\phi$1 and $\phi$3 electrodes is then deposited, the recess 30
ensuring that these electrodes can also be made to extend
across the full width of the mesa without contacting the $\phi$2
and $\phi$4 electrodes previously formed (Figure 10(c)). Any
superfluous metallisation 32' deposited by this evaporation
step will fall on the surface of the insulation area 31' to
isolate it from the electrode array 15. Similarly, the
insulation area 31 isolates the metallisation areas 32 from
the subsequently deposited electrode array 15'.

The $\phi$1 and $\phi$3 electrodes conveniently have the same
configuration as the $\phi$2 and $\phi$4 electrodes, but as mentioned
earlier are displaced with respect to them by half a gate period and
extend over the left hand edge of the mesa (as shown) and
terminate in respective contact pads or bus lines (not shown).

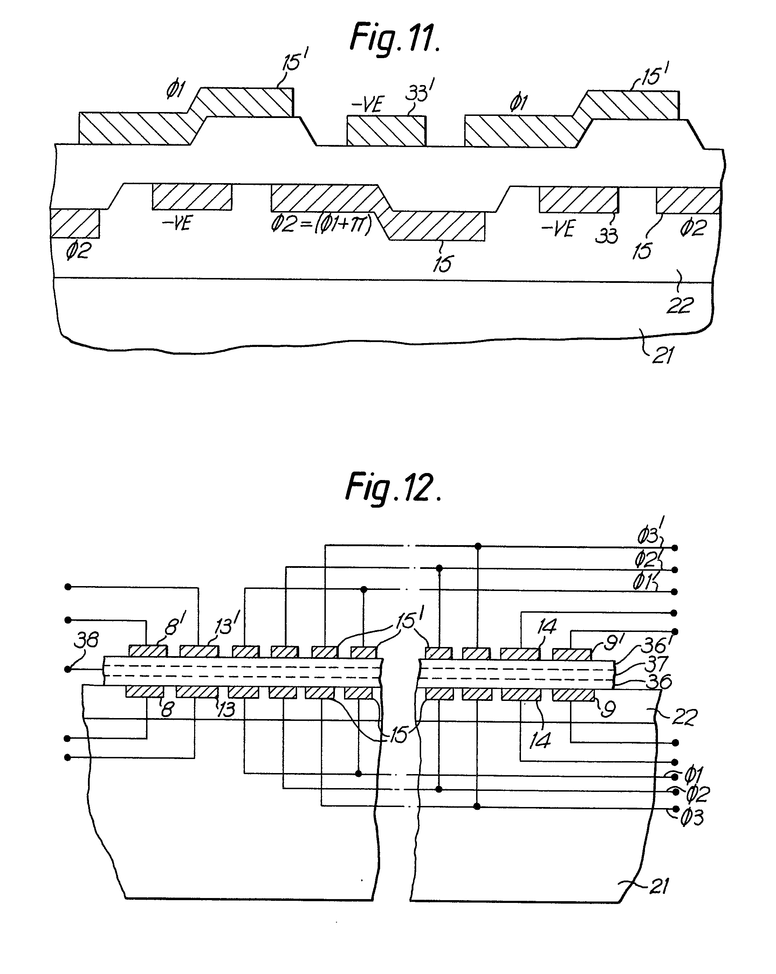

Figure 11 shows a modification of the Fig 9 device, adapted
for 2½phase operation. The top and bottom clocking
electrode arrays are identical, but displaced with respect to
one another by half a gate period, each comprising a single
phase array of stepped clocking gates 15, 15' with an array of
fixed (negative) potential biasing gates 33, 33' located

31

in the spaces between them. Typically, the width of the clocking gates 15, 15' is 4 microns, with an inter-electrode spacing of 3 microns. The biasing gates 33, 33' are about 1 micron wide. The depth of the channel is approximately 0.8 microns in the shallower regions increasing to about 1.6 microns in the stepped regions.

In operation, for an n-type channel, a fixed negative biasing potential is applied to all the biasing potential gates 33, 33' while antiphase sinusoidal clocking waves forms having a greater amplitude are applied to the waveforms applied to set 15 being in antiphase with those applied to set 15' respective sets of clocking electrodes 15, 15  The charge packets thus describe a zig-zag path, zig-zagging between the potential wells formed under alternate clocking electrodes on opposite surfaces of the channel region under the combined effect of the clocking waveforms and biassing potential applied to the electrodes 33, 33'. In addition charge is urged forward into the deeper potential well created by this stepped geometry.

In the double sided CCDs so far described, the gate electrode structures on both sides of the active layer are used to control and/or sample the movement of charge in a common buried channel within the active layer between them.

In the device shown in Figure 12 however, the gate electrodes 15, 15' on opposite sides of the active layer control the transfer of charge in separate charge transfer channels. As shown, the device is generally similar to that described with reference to Figure 3, except that both the upper and the lower electrode structures include input and output ohmic contacts 8, 9; 8', 9' and input and output transfer gate 13, 14; 13', 14', and the active layer has an n-p-n structure comprising lower and upper n-type channels 36, 36' separated by an intermediate p-type layer 37.

31

32

Typically both of the n-layers 36,36' have a thickness of about $\frac{1}{2}$ to $1\frac{1}{2}$ microns and a dopant-concentration of about $10^{16}$ carriers/$cm^3$, while the p-type layer is between 0.02 and 0.2 microns or greater depending upon its dopant concentration which may be the same as, higher or lower than that of the n-type layers, typically about $10^{15}$ to $10^{17}$ carriers/$cm^3$. The n-p-n active layer structure is grown in known manner in three successive stages, applying an appropriate dopant during the growth of each stage.

The upper and lower sets of clocking electrodes 15',15 may or may not be electrically connected to be driven by common clocking potentials, as each of the n-type layers 36, 36' of the active region provide independent charge transfer channels for the device.

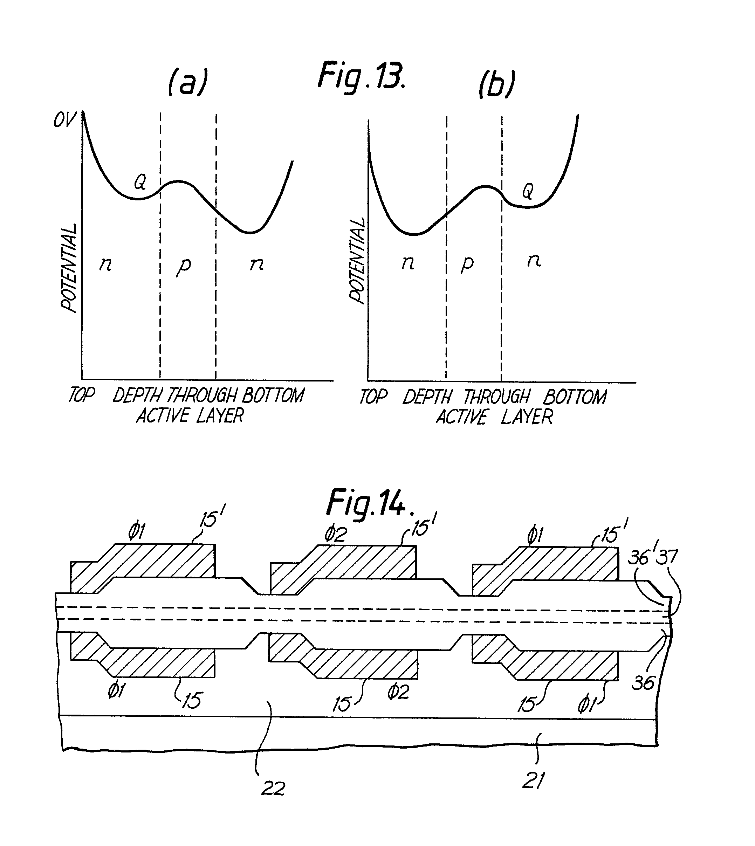

According to one mode of operation, all three layers 36,36',37 of the channel region are fully depleted in the absence of injected charge. With zero applied bias, and a charge packet beneath an upper electrode 15', the potential profile through the depth of the device is shown in Fig 13(a). With suitable clocking potentials, the charge will be constrained to remain in the upper n-type channel layer 36' and can be clocked along in the usual manner by means of electrodes 15'. However, upon application of a large negative voltage pulse to any one or more of the upper electrodes 15, charge in each of the corresponding charge packets in the upper channel layer will be caused to move vertically down into the lower channel layer 36. The resultant potential profile through the depth of the device is shown in Figure 13(b) for identical dopant concentrations in the n and p layers. The vertically transferred charge packet or packets can then be clocked along the lower channel 36 in either direction, by means of the lower set of electrodes 15 at the same or a different clocking frequency ( where the two sets of

32

electrodes are independently driven).  The upper
channel layer 36' is then free to receive further
charge which may be clocked along from its input
circuit.  It will be appreciated that charge transfer
may be effected either from the upper channel 36'
to the lower channel 36 as described, or vice versa.
As shown, each channel is provided with its own independent
input and output ohmic contacts 8,9; 8',9', and transfer
gates 13, 14; 13' 14', effectively providing two
separate independently controllable CCDs face-to-
face on a common supporting substrate, with the
facility for transferring charge vertically between
them and consequently the ability to move charge
packets along loops within the active region.

Alternatively, only the top layer, for example,
may have input and output ohmic contacts 8' and 9'
and transfer gates 13' and 14', contacts 8 and 9
and gates 13 and 14 being omitted from the bottom
layer.  Charge packets may then be input to the top
layer, moved to the bottom layer and transferred along
this layer before being moved back to the top layer
and output.

In a variant of this device, the intermediate
p-layer 37 is made slightly thicker so that it is
not fully depleted in the absence of injected charge
and an electrical connection is made to this layer
by an electrode 38 at an appropriate point on the
slice.  Vertical charge transfer from one of the

34

n-type channels 36, 36' to the other is then effected
by maintaining a higher potential on those electrodes
to which charge is to be transferred than on those
corresponding electrodes from which charge is to
be transferred. A positive potential pulse is then
applied to the non-depleted p-type layer 37,
causing charge in the appropriate packets in excess
of a certain minimum value to be vertically transferred
to the channel associated with the electrodes having
the higher applied potential where it can be processed
as described above. In this mode of operation, the
lower and upper clocking electrodes must be independently connected to enable different potentials to be
applied to them. Alternatively, the depth of one
of the n-type channel layers 36, 36' may be smaller
than the other, although vertical transfer of charge
in one direction only is possible in such an arrange-
ment.

35

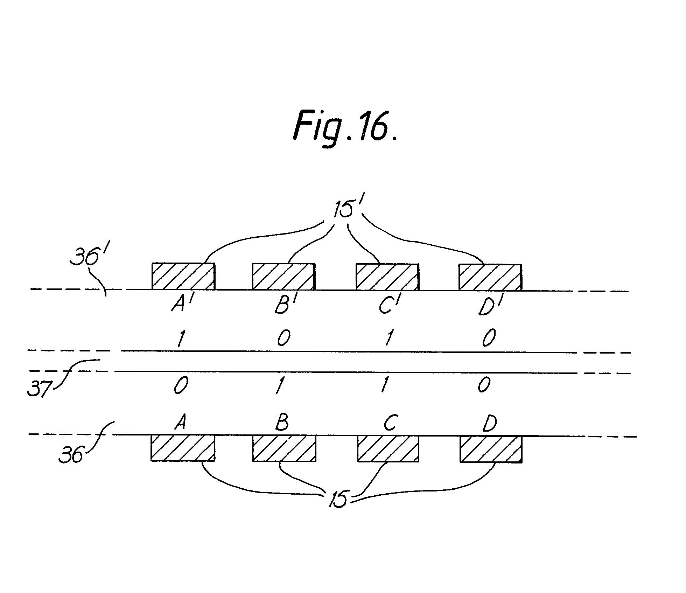

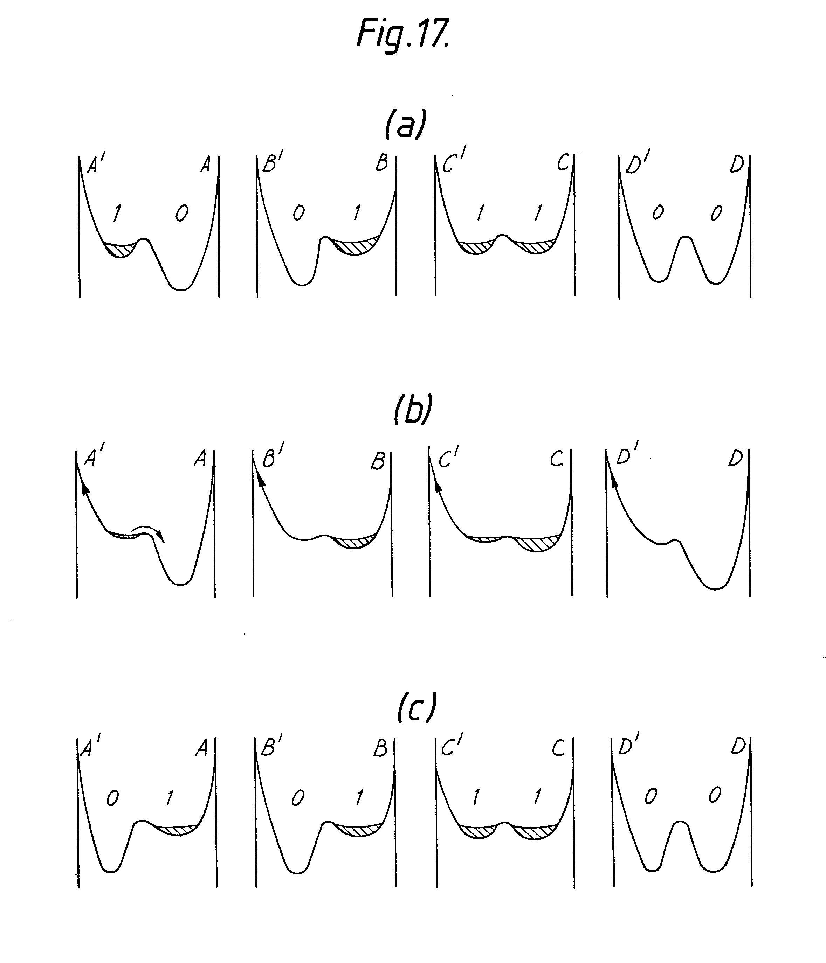

Logic applications of this type of device are
illustrated with reference to Fig. 16 which is a
schematic representation of a portion of the device
of Fig. 12 showing n-p-n channel layers 36', 37 and
36 sandwiched between four pairs of the gate electrodes
15' and 15 which are labelled A',A; B',B; C',C; and
D',D. The electrodes for the two layers are independently clocked to control charge packets in the two
channels 36 and 36', the presence of a packet
representing binary '1' and the absence of a packet
representing a binary '0'. In Fig. 16 binary signals
have been input to give a state A'=1, A=0, B'=0, B=1,
C'=1, C=1, D'=0, D=0. Voltages are then applied so
that charge packets in the top layer tend to move
vertically to the bottom layer. This causes transfer
of charge as illustrated in Fig. 17. Fig. 17(a) shows
an exaggerated potential profile across the active
layer of the portion in Fig. 16 at the positions of
the four electrode pairs prior to any vertical charge
transfers and Figs. 17(b) and 17(c) show profiles
during and after any transfer respectively. The result,
as can be seen in Fig. 17(c) is A'=0, A=1, B'=0,
B=1, C'=1, C=1, D'=0, D=0. The overall effect can
therefore be considered as the pairs of inputs A',A;
B',B; C',C; and D',D undergoing the logic operation
'AND', the result being fed to the upper channel 36'
and also undergoing the logic operation 'OR', the
result being fed to the lower channel 36, from where
the results may be output.

Clocking of signals in and out of the device may be either serial or parallel.

Some of the advantages of this multi-layer
device over previous CCD logic devices are that it
occupies a smaller area of substrate for the same
number of logic steps and therefore also takes less
time per step.

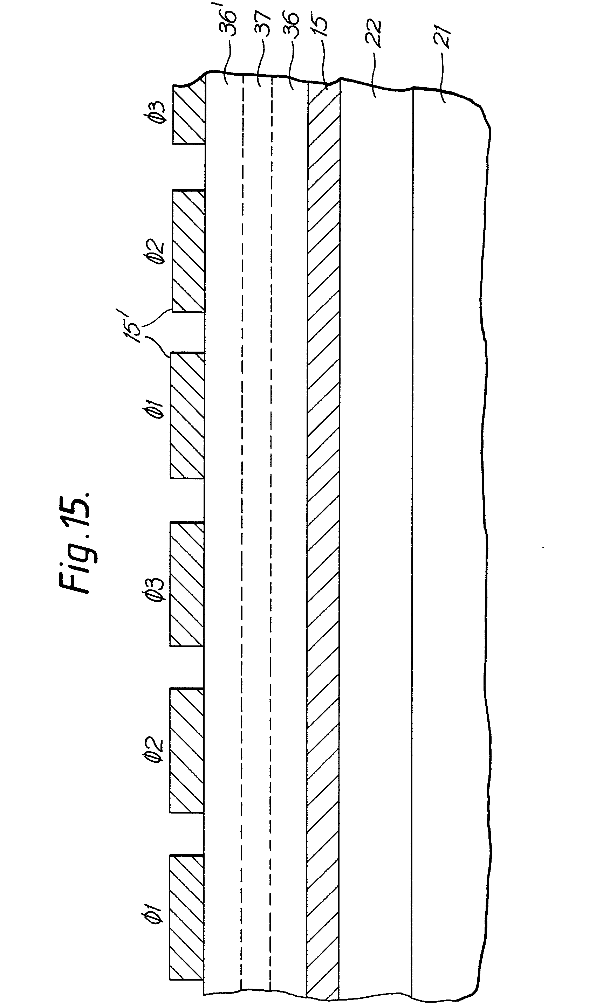

In the same way as the device of Figure 3 has
been modified by the inclusion of a three layer
n-p-n active region to produce the device shown in
figure 12, the 2- phase device shown in Figure 8
may be similarly modified, enabling 2-phase operation
to be achieved, as illustrated in Figure 14.

In both the figures 12 and14 devices, the 3
layer n-p-n active region may be replaced with a p-n-p active region, or by a three layer structure comprising an intermediate layer of one material sandwiched between two outer layers of a different material, for example GaAlAs sandwiched between two layers of GaAs, or vice-versa, to provide heterojunction barriers at the interfaces between the two materials. In such heterojunction structures the two materials may be either of the same or of different conductivity type, either p-type or n-type, and may be of the same or different dopant concentrations. The successive layers may readily be formed by epitaxial growth of succesive layers of the different materials in known manner, although the lattice structures of the two materials must be compatible to achieve this. Further, both arrangements may be adapted as described earlier to operate as transversal filters for example.

Figure 15 shows a further variant of the Figure 12 device in which the gate electrodes 15, 15' of the two arrays are arranged at right angles to one another appropriate for memory and logic applications. For such applications, the active layer may conveniently comprise GaAlAs for greatly increased storage times.

38

Similarly, in devices having independently controllable electrode arrays on opposite sides of an active layer having a single-layer structure, the electrodes of the two arrays may be non-parallel, eg $90^{\circ}$ to one another, to define a two dimensional matrix array of storage locations in the active layer at the crossover points of the two arrays.

Furthermore, in such two dimensional devices, whether having a single-or multi-layer active layer structure, the individual regions of the active layer defined at the cross-over points may be isolated from one another, for example by removing portions of the active layer surrounding them to define individual isolated mesas at the crossover points. Alternatively, a similar isolation effect may be achieved by proton or ion beam bombardment of portions of the active layer surrounding the individual active layer regions of the crossover points. Such devices may suitably be operated as charge storage or memory devices in which each storage location can be independently addressed (matrix addressing) by application of suitable potentials to appropriate ones of the electrodes of the two arrays.

To improve the charge handling capacity, or to optimise the location of the potential well, or to improve the quality of ohmic contacts made to the active layer, the dopant concentration of the or each layer of the active layer, in any of the devices discussed above, may be varied through its thickness in known manner. The application of this technique to insulated gate Si CCDs is discussed for example in "The Calculation of the Charge Handling Capacity in Twin Layer Peristaltic Charge-Coupled Devices "Wen N Lin et al, IEEE Transactions on Electron Devices, Vol ED-26,No.2, February 1979, pp 158-162.

39

Although the invention has been described in
its application to charge transfer devices fabricated
from GaAs, it will be appreciated that any other
suitable materials, such as GaAlAs, InP or Si may
alternatively be used. For example, in the
application of the present invention to the fabrication of Si CCDs, the active layer providing the
channel region or regions may be epitaxially grown
on a temporary Si substrate which is selectively
etchable against the active layer. The temporary
silicon substrate may advantageously comprise a
two layer structure consisting of a relatively thick
first layer and a relatively thin epitaxial second
layer on which the active layer is grown. If the
first layer is a different conductivity type, or
has a different dopant concentration to the first
layer then it may be selectively chemically or
electrochemically etched against the second layer.
Similarly, if the second layer is of a different
conductivity type, or has a different dopant
concentration to the adjacent active layer, then it
may also be selectively etched away against the
adjacent active layer using a chemical or electrochemical etching process. By providing a relatively
thin second, or buffer layer on the temporary Si
substrate against the active layer, very thin active
layers of good uniformity of thickness can be achieved.
Good uniformity may also be achieved by using, for
example, more than two temporary substrate layers.
Suitable chemical and electrochemical etching techniques are described in Theunissen et al "Application of Preferential Electrochemical Etching of Silicon to Semiconductor Device Technology" J Electrochem Society, Electrochemical Technology, Vol 117, No.7, July 1970, pages 959 to 965, in C P Wen et al "Preferential Electrochemical Etching of P Silicon in an Aqueous HF - $H_2SO_4$ Electrolyte" J Electrochem Soc. Vol 119, April 1972, No.4 pp 547- 548; and in C J Rhee et al "Integral Heat-Sink Impatt Diodes Fabricated using $P^+$ Etch Stop". Proc IEEE Vol 61, No.3 p 385- 387 March 1973.  It will be appreciated however, that Schottky barrier electrodes cannot be used on Si devices, these normally being replaced by gate electrode structures insulated from the active layer by an insulating layer eg of $SiO_2$.

Also, although two, three or four-phase clocking has been described with respect to particular embodiments, it will be appreciated by one skilled in the art that different clocking arrangements may be employed to the particular devices.

Additionally, although any embodiments of devices having arrays of gate electrodes each of the same width have been described, devices having gate electrodes of different widths may also be fabricated.

41

## CLAIMS

1.     A charge transfer device including:

an active layer of semiconductor material providing charge transfer channel means, and supported on a support substrate, a lower array of gate electrodes for sampling or controlling charge transfer within the transfer channel means, lower pulse reciever conductors associated with the lower gate electrodes for reception of phase clocking pulses, the lower gate electrodes being disposed between the support substrate and the active layer.

2.     A charge transfer device according to Claim 1 which also includes an upper array of gate electrodes and upper pulse reciever conductors associated with the upper gate electrodes for reception of phase clocking pulses such that the active layer is disposed between the upper and the lower gate electrodes.

3.     A charge transfer device according to Claim 2 wherein the active layer, the upper and lower gate electrodes are symmetrically disposed.

4.     A charge transfer device according to Claim 2 wherein the active layer, the upper and lower gate electrodes are asymmetrically disposed such that one of the electrode arrays is staggered in the direction of charge transfer with respect to the other.

41

42

5.    A charge transfer device according to any of
Claims 2 to 4 wherein the upper pulse receiver
conductors are independent of the lower pulse
receiver conductors.

6.    A charge transfer device according to any of
Claims 2 to 4 wherein the upper pulse receiver
conductors are connected to receive the same pulses
as the lower pulse receiver conductors.

7.    A charge transfer device according to any of
claims 2 to 5 wherein the upper and lower gate
electrodes do not lie along the same directions.

8.    A charge transfer device according to Claim 7
wherein the upper gate electrodes comprise an array
of parallel conducting strips lying along a first
direction and the lower gate electrodes comprise an
array of parallel conducting strips lying along a
direction perpendicular to the first direction.

9.    A charge transfer device according to either of
Claims 7 and 8 wherein the portions of active layer
corresponding to the cross-over points of the upper
and lower gate electrodes are isolated from the
remainder of the active layer.

10.    A charge transfer device according to any of
Claims 2 to 9 wherein the upper array of gate
electrodes include electrodes which are transparent
to radiation.

11.    A charge transfer device according to Claim 10 wherein the upper array of gate electrodes which are transparent to radiation are formed of highly doped gallium aluminum arsenide.

12.   A charge transfer device according to any of Claims 7 to 9 wherein the active layer is formed of of gallium aluminum arsenide semiconductor material.

13.   A charge transfer device according to any of preceding claim wherein the gate electrodes form rectifying junctions with the active layer.

14.   A charge transfer device according to any of Claims 1 to 11, or 13 wherein the active layer is gallium arsenide semiconductor material and the electrodes form Schottky-barrier junctions with the active layer.

15.   A charge transfer device according to any of the preceding Claims wherein the depth of the active layer has a step increase in the direction of charge transfer adjacent to each gate electrode.

16.   A charge transfer device according to Claim 15 wherein the pulse receiver conductors are adapted for two phase clocking.

17.   A charge transfer device according to any of the preceding Claims wherein a selection of the gate electrodes are split along their lengths for transverse filtering.

18.   A charge transfer device according to Claim 17 which further includes an array of logic gates for interconnecting the split electrodes to provide a selection of different filtering characteristics.

44

19. A charge transfer device according to Claim 18 wherein the logic gates are integrated on the same support substrate as the active layer and the gate electrodes.

20. A charge transfer device according to any of Claims 17 to 19 wherein the split gate electrodes are included in only one of either the upper or the lower arrays of gate electrodes.

21. A charge transfer device according to any of Claims 2 to 11, 13 or 15 to 20 wherein the active layer comprises a plurality of layers of semiconductor material, two outer layers of which lie adjacent to the upper and the lower gate electrodes.

22. A charge transfer device according to Claim 21 wherein each junction between adjacent layers of semiconductor material in the active layer constitutes a barrier junction.

23. A charge transfer device according to Claim 21 or 22 wherein the active layer comprises two layers of semiconductor material.

24. A charge transfer device according to either of Claims 21 or 22 wherein the active layer comprises a three-layer structure of an intermediate layer of semiconductor material sandwiched between the two outer layer of semiconductor material.

25. A charge transfer device according to Claim 23 or 24 wherein the or each barrier junction comprises a homojunction.

44

26.   A charge transfer device according to Claim
23 or 24 wherein the or each barrier comprises a
heterojunction.

27.   A charge transfer device according to any of
Claims 21 to 26 wherein the two outer layers of
semiconductor material form upper and lower charge
transfer channels respectively.

28.   A charge transfer device according to any of
Claims 21 to 27 wherein the layers of semiconductor
material are fully depleted in the absence of injected
charge.

29.   A charge transfer device according to Claim 24
wherein the intermediate layer is non-depleted and
the two outer layers are fully depleted of charge
in the absence of injected charge and further including
conductor means connected for applying voltage bias
signals to the intermediate layer.

30.   A charge transfer device according to any of
Claims 21 to 29 wherein one of the outer layers of
semiconductor material is thicker than the other outer
layer of semiconductor material.

31.   A charge transfer device according to any of
Claims 21 to 30 wherein the layers of semiconductor
material are epitaxially formed

32.   A chage transfer device substantially as
herein described with reference to the accompanying
drawings.

46

33.    A method of fabricating a charge transfer
device including the steps of:
forming an active layer of semiconductor
material on the surface of a temporary
substrate,
forming an array of lower gate electrodes
over the surface of the active layer,
applying a support substrate to the surface
of the active layer carrying the lower
electrode array,
and removing the temporary substrate.

34.    A method  of fabricating a charge transfer device
according to Claim 33 further followed by the step of
forming an array of upper gate electrodes on the
surface of the active layer left free after removal
of the temporary substrate.

35.    A method of fabricating a charge transfer device
according to either of Claims 33 or 34 wherein the
temporary substrate comprises a plurality of layers.

36.    A method of fabricating a charge transfer device
according to any of Claims 33 to 35 wherein the
temporary substrate is removed by selective etching
with etchant or etchants which attack the or each
temporary substrate layer at a faster rate than the
adjacent or underlying material.

37.    A method of fabricating a charge transfer device
according to any of Claims 33 to 36 wherein the
temporary substrate comprises a thick layer of

47

gallium arsenide adjacent to a thin buffer layer of
gallium aluminum arsenide and the active layer
comprises a layer of gallium arsenide semiconductor
which is formed on the gallium aluminum arsenide.

38. A method of fabricating a charge transfer device
according to any of Claims 33 to 37 wherein the
support substrate is applied to the surface of the
active layer carrying the array of lower gate
electrodes by first forming an insulating coating on
the active layer then bonding the support substrate
to the coating.

39. A method of fabricating a charge transfer device
according to Claim 38 wherein the coating comprises
polyimide.

40. A method of fabricating a charge transfer device
according to either of claims 38 or 39 wherein the
support substrate is bonded to the coating using
an adhesive.

41. A method of fabricating a charge transfer device
according to Claim 40 wherein the adhesive is
polyimide.

42. A method of fabricating a charge transfer device
according to any of Claims 38 to 41 wherein the
support substrate comprises a conducting material.

43. A method of fabricating a charge transfer device
according to any of Claims 33 to 42 wherein the active
layer is formed on the temporary substrate by
epitaxial growth of a plurality of semiconductor

48

material layers.

44. A method of fabricating a charge transfer device according to any of Claims 33 to 43 wherein the active layer includes a layer of semiconductor material with a nonuniform doping level profile.

45. A method of fabricating a charge transfer device according to any of Claims 33 to 44 wherein, after removal of the temporary substrate, a surface thickness of exposed active layer is also removed.

46. A method of fabricating a charge transfer device substantially as hereinbefore described.

1/10
Fig.1.

(a)

(b)

(c)

Fig.2.

Fig.3.

Fig.4.

Fig.5.

## Fig.6.

$\phi 3$

$\phi 2^{+}$

$\phi 2^{-}$

$\phi 1$

15

15'

$\underline{4}$

22

$\phi 2^{+}$ OR $\phi 4^{+}$

$\phi 2^{-}$ OR $\phi 4^{-}$

21

## Fig.7.

29

28

15'

$\underline{4}$

15

22

21

18    $\phi 1$

26    $\phi 2$

20    $\phi 3$

## Fig.8.

$\phi 1$          $\phi 2$      31        $\phi 1$

15'

$\underline{4}$

$\phi 1$      15      $\phi 2$      30      $\phi 1$

22

21

## Fig.9.

4 PHASE   Ø1      Ø3      Ø1      Ø3
3 PHASE   Ø1   15'   Ø3      Ø2      Ø1

_4_

15

3 PHASE   Ø2     Ø1     Ø3     Ø2
4 PHASE   Ø2     Ø4     Ø2     Ø4

21     22

## Fig.10.

### (a)

32     15
_4_
3
2
1

### (b)

31     32     15   30   31'
_4_
22
21

### (c)

15'   30   32'   31'
31   32    4
15
22
21

## Fig.11.

$\phi 1$    15'    $-VE$   33'    $\phi 1$    15'

$\phi 2$    $-VE$    $\phi 2=(\phi 1+\pi)$    $-VE$   33   15   $\phi 2$

15

22

21

## Fig.12.

$\phi 3'$
$\phi 2'$
$\phi 1'$

38   8'   13'    15'    14    9'   36'

37

36

8   13    15    14   9   22

$\phi 1$
$\phi 2$
$\phi 3$

21

## Fig.13.

(a)

(b)

## Fig.14.

## Fig.15.

$\emptyset1$  $\emptyset2$  $\emptyset3$  $\emptyset1$  $15'$  $\emptyset2$  $\emptyset3$

36'

37

36

15

22

21

0025658

# Fig.16.

Fig.17.